(19) Europäisches Patentamt
European Patent Office
Office européen des brevets

(11) EP 4 746 650 A1

(12) EUROPEAN PATENT APPLICATION
published in accordance with Art. 153(4) EPC

(43) Date of publication:
20.05.2026 Bulletin 2026/21

(21) Application number: 24847667.3

(22) Date of filing: 24.04.2024

(51) International Patent Classification (IPC):
*H10K 30/50* (2023.01)

(52) Cooperative Patent Classification (CPC):
H10K 30/50; H10K 30/85; H10K 30/88;
H10K 71/16; H10K 2101/30; Y02E 10/549

(86) International application number:
PCT/CN2024/089625

(87) International publication number:
WO 2025/025701 (06.02.2025 Gazette 2025/06)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.08.2023 CN 202310967471

(71) Applicant: Contemporary Amperex Technology
Co., Limited
Ningde, Fujian 352100 (CN)

(72) Inventors:
• MA, Junfu
Ningde, Fujian 352100 (CN)
• TU, Bao
Ningde, Fujian 352100 (CN)
• CHEN, Changsong
Ningde, Fujian 352100 (CN)
• GUO, Yongsheng
Ningde, Fujian 352100 (CN)
• OUYANG, Chuying
Ningde, Fujian 352100 (CN)

(74) Representative: Kraus & Lederer PartGmbB
Thomas-Wimmer-Ring 15
80539 München (DE)

(54) **SOLAR CELL AND MANUFACTURING METHOD THEREFOR, SOLAR CELL ASSEMBLY AND MANUFACTURING METHOD THEREFOR, AND ELECTRIC DEVICE**

(57) The present application provides a solar cell and a manufacturing method therefor, a solar cell module and a manufacturing method therefor, and an electrical device. The solar cell includes: a first electrode layer, an active layer, a second electrode layer, and a blocking layer stacked in sequence, where the blocking layer is located between the active layer and the second electrode layer or located between the active layer and the first electrode layer, and the blocking layer includes an n-type semiconductor oxide. The n-type semiconductor oxide is made from an inorganic material and has higher heat resistance compared with traditional blocking layer materials such as bathocuproine. Therefore, using the n-type semiconductor oxide as the blocking layer can make the solar cell have higher thermal stability.

FIG. 7

EP 4 746 650 A1

## Description

### CROSS-REFERENCE

The present application claims the priority of Chinese Patent Application No. 202310967471.9 filed on August 02, 2023 and entitled "SOLAR CELL AND MANUFACTURING METHOD THEREFOR, SOLAR CELL MODULE AND MANUFACTURING METHOD THEREFOR, AND ELECTRICAL DEVICE", the entire contents of which are incorporated herein by reference.

### TECHNICAL FIELD

The present application relates to the technical field of solar cell devices, and in particular, to a solar cell and a manufacturing method therefor, a solar cell module and a manufacturing method therefor, and an electrical device.

### BACKGROUND

With the large-scale development and utilization of non-renewable energy sources such as coal and petroleum, their reserves can no longer meet the demands of agricultural and industrial development and the like. Therefore, recycled and renewable energy sources have gradually become one of the alternative energy sources to non-renewable energy sources to promote social and industrial development. Especially, solar cell devices are widely used due to their characteristics of being green and environmentally friendly and being able to generate electrical energy upon sunlight exposure.

However, in the related art, the solar cell devices have poor heat resistance, resulting in a short service life, which limits their further promotion and application.

### SUMMARY OF THE INVENTION

The present application provides a solar cell and a manufacturing method therefor, a solar cell module and a manufacturing method therefor, and an electrical device. The solar cell and the solar cell module have high thermal stability.

In a first aspect, an embodiment of the present application provides a solar cell, including: a first electrode layer, an active layer, a second electrode layer, and a blocking layer stacked in sequence, where the blocking layer is located between the active layer and the second electrode layer or located between the active layer and the first electrode layer, and the blocking layer includes an n-type semiconductor oxide.

The n-type semiconductor oxide is made from an inorganic material and has higher heat resistance compared with traditional blocking layer materials such as bathocuproine. Therefore, using the n-type semiconductor oxide as the blocking layer can make the solar cell have higher thermal stability.

In any embodiment, hole mobility of the n-type semiconductor oxide is not greater than 1000 $cm^2V^{-1}s^{-1}$, optionally 0.1 $cm^2V^{-1}s^{-1}$ to 1000 $cm^2V^{-1}s^{-1}$.

The n-type semiconductor oxide has low hole mobility, which can effectively reduce the migration speed of holes, thereby blocking the holes, reducing charge carrier recombination, and improving photoelectric conversion efficiency.

In any embodiment, the n-type semiconductor oxide includes at least one of tin oxide, titanium oxide, zinc oxide, indium oxide, and gallium oxide.

In any embodiment, the n-type semiconductor oxide includes tin oxide.

Tin oxide also has high electron mobility, which can not only block the diffusion of the holes to a cathode, but also promote the transmission of electrons to the cathode. Therefore, it is beneficial to further improve the photoelectric conversion efficiency of the solar cell.

In any embodiment, a thickness of the blocking layer is 5 nm to 35 nm, optionally 10 nm to 30 nm.

When the thickness of the blocking layer is within an appropriate range, the thermal stability and the photoelectric conversion efficiency of the solar cell can be improved simultaneously.

In any embodiment, the blocking layer is arranged between the second electrode layer and the active layer.

An electric field is in the active layer (such as a perovskite compound), and halogen anions are prone to diffusion under the action of the electric field. The halogen anions have a low diffusion rate in n-type semiconductors. Using the n-type semiconductor oxide as the blocking layer can also act as a passivation layer, thereby effectively blocking the diffusion of the halogen anions in the perovskite compound to the second electrode layer, slowing down the corrosion of the second electrode layer (such as a metal electrode), and improving the stability and the photoelectric conversion efficiency of the solar cell.

In any embodiment, the blocking layer further includes an extending part arranged on at least one side surface of the active layer.

The extending part arranged on at least one side surface of the active layer can form a semi-encapsulated structure for the solar cell, thereby effectively preventing water and oxygen in the air from entering the active layer, especially preventing water and oxygen from aging a light-absorbing layer in the active layer, slowing down the degradation of a perovskite material in the external environment, and improving the photoelectric conversion efficiency and the stability of the device.

In any embodiment, all parts of the blocking layer are formed simultaneously.

All the parts of the blocking layer are formed simultaneously during the deposition process, which can effectively improve the forming efficiency of the solar cell and alleviate the deterioration of the photoelectric conversion efficiency caused by damage to the active layer in multiple sequential deposition processes.

In any embodiment, the blocking layer is prepared by an atomic layer deposition method.

A thin film prepared by the atomic layer deposition method has high compactness and can effectively block the diffusion of the halogen anions in the active layer to the second electrode layer, and particularly, can alleviate the corrosion of the halogen anions to metal in the electrode layer, thereby effectively improving the stability and the photoelectric conversion efficiency of the solar cell. At the same time, the atomic layer deposition method is to alternately introduce gas phase precursor pulses into a reaction container. A first reaction precursor may be chemically adsorbed on a substrate. When being introduced into the reaction container, a second precursor will react with the previous precursor that has been adsorbed on a surface of the substrate to form the thin film. Therefore, film formation through the atomic layer deposition method is not restricted by the direction or angle, and the reaction precursor can be freely adsorbed on any exposed surface of the active layer, so that the parts of the blocking layer in all directions can be formed simultaneously, which has the characteristics of high production efficiency and low costs.

A film layer prepared by the atomic layer deposition method is compact and has a low ion diffusion rate, which can, compared with other deposition methods, more effectively block the migration of halogen ions in the active layer to the electrode layer, and alleviate the corrosion of the halogen ions to the electrode layer, especially to a metal electrode, thereby improving the photoelectric conversion efficiency and the device stability of the solar cell.

In any embodiment, the active layer includes a light-absorbing layer, and optionally, the light-absorbing layer includes a perovskite compound.

In any embodiment, the active layer further includes an electron transport layer, and the electron transport layer is arranged between the light-absorbing layer and the blocking layer.

The blocking layer is arranged on a surface of the electron transport layer. Compared with the blocking layer being directly arranged on a surface of the light-absorbing layer, the damage to the light-absorbing layer caused in the deposition process of the blocking layer can be effectively reduced, and the negative impacts on the photoelectric conversion efficiency can be reduced.

In any embodiment, the active layer further includes a hole transport layer, and the hole transport layer is arranged on a side of the light-absorbing layer facing away from the blocking layer.

In any embodiment, a highest occupied molecular orbital (HOMO) energy level of the n-type semiconductor oxide is lower than a HOMO energy level of the light-absorbing layer.

The HOMO of the n-type semiconductor oxide has the energy level lower than that of the HOMO of the electron transport layer and/or the light-absorbing layer, so that diffusion of the holes from the HOMO of the light-absorbing layer to the HOMO of the n-type semiconductor oxide can be blocked, thereby acting as a hole blocking layer.

In a second aspect, the present application provides a preparation method for a solar cell. The preparation method includes: providing a first electrode layer; forming an active layer on at least one side of the first electrode layer; forming a blocking layer on a side of the active layer facing away from the first electrode layer; and forming a second electrode layer on a side of the blocking layer facing away from the first electrode layer, where the blocking layer includes an n-type semiconductor oxide, optionally including at least one of tin oxide, titanium oxide, zinc oxide, indium oxide, and gallium oxide.

In any embodiment, the blocking layer further includes an extending part arranged on at least one side surface of the active layer.

In any embodiment, a forming method of the blocking layer is an atomic layer deposition method.

In a third aspect, the present application provides a solar cell module, including a first electrode layer, an active layer, a blocking layer, and a second electrode layer stacked in sequence, where the blocking layer includes an n-type semiconductor oxide, optionally including at least one of tin oxide, titanium oxide, zinc oxide, indium oxide, and gallium oxide.

Using the n-type semiconductor oxide as the blocking layer can block the migration of holes toward a cathode. The n-type semiconductor oxide is made from an inorganic material and has higher heat resistance compared with traditional blocking layer materials such as bathocuproine, so that the solar cell module has higher thermal stability.

In any embodiment, the first electrode layer includes a plurality of conductive blocks that are not connected to each other, and a first separation groove is formed between every two adjacent conductive blocks; the active layer includes a plurality of active blocks, and a second separation groove is formed between every two adjacent active blocks, a bottom surface of the second separation groove is arranged on the first electrode layer, and an opening of the second separation groove is formed in an upper surface of the active layer; the second electrode layer is arranged on the blocking layer, and the second electrode layer is further provided with a longitudinal part extending toward the first electrode layer, the longitudinal part passes through the second separation groove, and a tail end of the longitudinal part is connected to the bottom surface of the second separation groove; the solar cell module further includes a third separation groove, an opening of the third separation groove is formed in an upper surface of the second electrode layer, and a bottom surface of the third separation groove is arranged on the first electrode layer.

The above-mentioned arrangement enables single solar cells to be connected in series to form the solar cell module through the simple arrangement of the separation groove, thereby effectively improving the preparation efficiency of the solar cell module.

In any embodiment, the blocking layer at least includes a first horizontal part located on an upper surface of the active block and a first extending part extending toward the first electrode, and the first extending part is arranged on at least one side surface of the active layer adjacent to the second separation groove.

The first horizontal part and the first extending part of the blocking layer can respectively inhibit the longitudinal migration and lateral migration of halogen anions in the active layer to the second electrode layer, thereby slowing down the corrosion to the second electrode layer and improving the stability and the photoelectric conversion efficiency of the solar cell module.

In any embodiment, the blocking layer further includes a second horizontal part located on the bottom surface of the second separation groove; a fourth separation groove is formed in the second horizontal part, and the longitudinal part of the second electrode layer passes through the fourth separation groove, so that the tail end thereof is connected to the first electrode layer on the bottom surface of the second separation groove.

The longitudinal part of the second electrode layer passes through the fourth separation groove, so that the tail end thereof is connected to the first electrode layer on the bottom surface of the second separation groove, which can reduce the series resistance between the single solar cells and improve the photoelectric conversion efficiency of the solar cell module.

In any embodiment, a width of the fourth separation groove is less than that of the second separation groove.

The above-mentioned arrangement enables the tail end of the longitudinal part of the second electrode layer to be connected to the first electrode layer on the bottom surface of the second separation groove, and the arrangement of the fourth separation groove will not destroy the first extending part of the blocking layer, so that the blocking layer can play an effective blocking role, thereby avoiding other negative effects on the photoelectric conversion efficiency and the stability of the solar cell module.

In any embodiment, the blocking layer is prepared by an atomic layer deposition method, and optionally, a thickness of the blocking layer is 5 nm to 35 nm, optionally, 10 nm to 30 nm.

In any embodiment, the active layer includes a light-absorbing layer, optionally, the light-absorbing layer includes a perovskite compound, optionally, the active layer further includes an electron transport layer, and the electron transport layer is arranged between the light-absorbing layer and the blocking layer; optionally, the active layer further includes a hole transport layer, and the hole transport layer is arranged between the light-absorbing layer of the cell and the first electrode layer.

In a fourth aspect, the present application provides a preparation method for a solar cell module. The preparation method includes: providing a first electrode layer; forming at least one first separation groove in the first electrode layer, where the first separation groove divides the first electrode layer into a plurality of conductive blocks that are not connected to each other; forming an active layer on at least one side of the first electrode layer; forming at least one second separation groove in the active layer, where a bottom surface of the second separation groove is arranged on the first electrode layer, and an opening of the second separation groove is formed in an upper surface of the active layer; forming a blocking layer on a side of the active layer facing away from the first electrode layer; forming a second electrode layer on a side of the blocking layer facing away from the first electrode layer, where the second electrode layer is provided with a longitudinal part extending toward the first electrode layer, the second separation groove is filled with the longitudinal part, and a tail end of the longitudinal part is connected to the first electrode layer at a bottom of the second separation groove; and forming a third separation groove, where an opening of the third separation groove is formed in an upper surface of the second electrode layer, and a bottom surface of the third separation groove is arranged on the first electrode layer; where the blocking layer includes an n-type semiconductor oxide, optionally including at least one of tin oxide, titanium oxide, zinc oxide, indium oxide, and gallium oxide.

In any embodiment, the blocking layer is formed at least on an upper surface of the active block and at least one side surface of the active block adjacent to the second separation groove.

In any embodiment, the blocking layer is prepared by an atomic layer deposition method.

In any embodiment, the blocking layer is further formed in the bottom surface of the second separation groove; a fourth separation groove is formed in the blocking layer located on the bottom surface of the second separation groove, the longitudinal part of the second electrode layer passes through the fourth separation groove, and the tail end of the longitudinal part is connected to the first electrode layer on the bottom surface of the second separation groove.

In a fifth aspect, the present application provides an electrical device, including the solar cell in the first aspect of the present application or a solar cell prepared by the preparation method in the second aspect of the present application or the solar cell module in the third aspect of the present application or a solar cell module prepared by the preparation method in the fourth aspect of the present application.

The above-mentioned description is merely an overview of the technical solutions of the present application. In order that technical means of the present application can be understood more clearly so that the technical means can be implemented according to content of the specification, and in order that the above-mentioned and other objectives, features, and advantages of the present application can be understood more clearly, specific embodiments of the present application are described below.

BRIEF DESCRIPTION OF DRAWINGS

By reading the detailed description of the preferred embodiments below, various other advantages and benefits will become apparent to those of ordinary skill in the art. The drawings are used for the purpose of illustrating the preferred embodiments only and are not to be considered a limitation to the present application. In addition, throughout the accompanying drawings, the same reference numeral is used to represent the same component. In the accompanying drawings:

FIG. 1 shows a schematic sectional view of a solar cell according to some embodiments of the present application;
FIG. 2 shows a schematic sectional view of a solar cell according to some embodiments of the present application;
FIG. 3 shows a schematic sectional view of a solar cell according to some embodiments of the present application;
FIG. 4 shows a schematic sectional view of a solar cell according to some embodiments of the present application;
FIG. 5 shows a schematic sectional view of a solar cell according to some embodiments of the present application;
FIG. 6 shows a schematic view of an energy level of a solar cell according to some embodiments of the present application;
FIG. 7 shows a schematic sectional view of a solar cell module according to some embodiments of the present application; and
FIG. 8 shows an $I^{3d}$ X-ray photoelectron spectroscopy (XPS) spectrum in a second electrode layer of a solar cell module in Example 1 and Comparative Example 1 of the present application after aging.

Reference numerals in specific embodiments are as follows:

Solar cell 1-1, 1-2, 1-3, 1-4, and 1-5;
solar cell module 2;
first electrode layer 10 and 20;
active layer 11 and 21, light-absorbing layer 111, electron transport layer 112, hole transport layer 113,
second electrode layer 12 and 22; longitudinal part 221;
blocking layer 13 and 23; extending part 131; first horizontal part 232; first extending part 231; second horizontal part 233;
first separation groove P-1; second separation groove P-2; third separation groove P-3; fourth separation groove P-4.

**DETAILED DESCRIPTION**

The embodiments of the technical solutions of the present application will be described in detail below with reference to the accompanying drawings. The following embodiments are only used to more clearly illustrate the technical solutions of the present application, therefore only as examples, and cannot be used to limit the scope of protection of the present application.

Unless otherwise defined, all technical and scientific terms used herein have the same meanings as commonly understood by those skilled in the technical field to which the present application belongs. The terms used herein are intended only for the purpose of describing specific embodiments and are not intended to limit the present application. The terms "include" and "have" and any variations thereof in the specification and the claims of the present application and in the above Description of Drawings are intended to encompass non-exclusive inclusion.

In the description of the embodiments of the present application, the technical terms "first", "second", and the like, are used only to distinguish between different objects and are not to be understood as indicating or implying relative importance or implicitly specifying the number, particular order, or primary and secondary relationship of the technical features indicated. In the description of the embodiments of the present application, the meaning of "a plurality of" is two or more, unless otherwise explicitly and specifically defined.

Reference to "an embodiment" herein means that a particular feature, structure, or characteristic described with reference to an embodiment can be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present application, the term "and/or" is merely an association that describes the associated object, indicating that there can be three kinds of relationships, such as A and/or B, which can be denoted as: the existence of A alone, the existence of A and B at the same time, and the existence of B alone. Moreover, the character "/" herein generally indicates that the context objects are in an "or" relationship.

In the description of the embodiments of the present application, the term "a plurality of" refers to more than two (including two). Similarly, "a plurality of groups" refers to more than two groups (including two groups), and "a plurality of pieces" refers to more than two pieces (including two pieces).

In the description of the embodiments of the present application, the orientation or positional relationships indicated by the technical terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like are based on the orientation or positional relationships shown in the accompanying drawings, and are only for the convenience of describing the embodiments of the present application and simplifying the description, and do not indicate or imply that the apparatus or element referred to must have a specific orientation or be constructed and operated in a specific orientation, and therefore cannot be construed as a restriction on the embodiments of the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above-mentioned terms in the embodiments of the present application can be understood according to specific situations.

2,9-dimethyl-4,7-diphenyl-1,10-phenanthroline (bathocuproine, BCP) is a commonly used blocking layer material in solar cells (especially perovskite solar cells). It improves the photoelectric conversion efficiency of the solar cells by blocking the migration of holes toward a cathode. However, bathocuproine is an organic substance that easily agglomerates under heat, resulting in poor thermal stability of the solar cells.

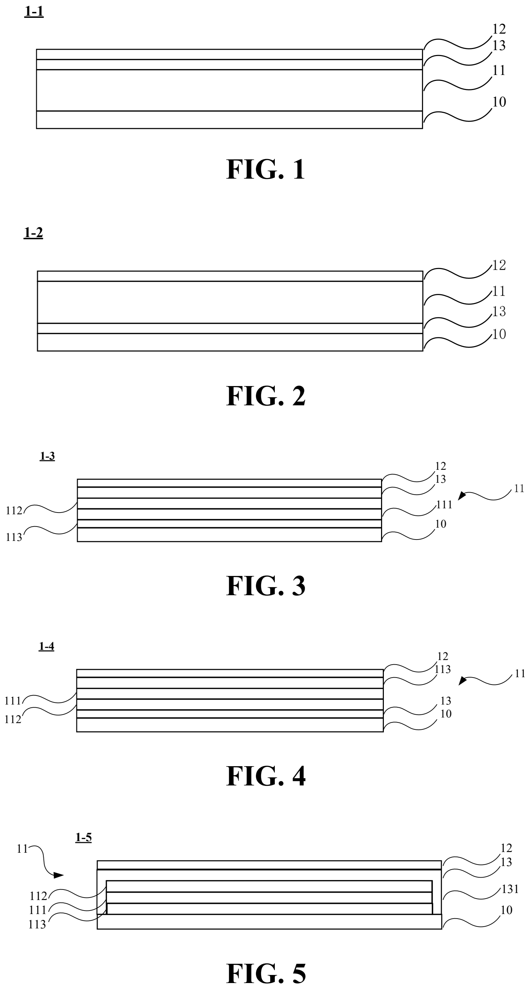

Based on this, as shown in FIG. 1 and FIG. 2, in a first aspect, the present application provides a solar cell 1-1 and 1-2, which includes a first electrode layer 10, an active layer 11, a second electrode layer 12, and a blocking layer 13 stacked in sequence, where the blocking layer 13 is located between the active layer 11 and the second electrode layer 12 or located between the active layer 11 and the first electrode layer 10, and the blocking layer 13 includes an n-type semiconductor oxide.

The n-type semiconductor oxide is also called an electron type semiconductor oxide, that is, an impurity semiconductor oxide in which the free electron concentration is much greater than the hole concentration.

In some embodiments, the blocking layer is a hole blocking layer.

The n-type semiconductor oxide is made from an inorganic material and has higher heat resistance compared with traditional blocking layer materials such as bathocuproin. Therefore, using the n-type semiconductor oxide as the blocking layer can make the cell have higher thermal stability.

In some embodiments, hole mobility of the n-type semiconductor oxide is not greater than 1000 $cm^2V^{-1}s^{-1}$. In some embodiments, hole mobility of the n-type semiconductor oxide is 0.1 $cm^2V^{-1}s^{-1}$ to 1000 $cm^2V^{-1}s^{-1}$.

The hole mobility refers to a rate at which holes move under the action of an electric field.

In some embodiments, hole mobility of the n-type semiconductor oxide is optionally 0.1 $cm^2V^{-1}s^{-1}$, 1 $cm^2V^{-1}s^{-1}$, 10 $cm^2V^{-1}s^{-1}$, 100 $cm^2V^{-1}s^{-1}$, 500 $cm^2V^{-1}s^{-1}$, 1000 $cm^2V^{-1}s^{-1}$, or any value therebetween.

The n-type semiconductor oxide has low hole mobility, which can effectively reduce the migration speed of holes, thereby blocking the holes, reducing charge carrier recombination, and improving photoelectric conversion efficiency.

In some embodiments, the n-type semiconductor oxide includes at least one of tin oxide, titanium oxide, zinc oxide, indium oxide, and gallium oxide. In some embodiments, the n-type semiconductor oxide includes tin oxide.

Tin oxide also has high electron mobility, which can not only block the diffusion of the holes to a cathode, but also promote the transmission of electrons to the cathode. Therefore, it is beneficial to further improve the photoelectric conversion efficiency of the solar cell.

In some embodiments, a thickness of the blocking layer 13 is 5 nm to 35 nm. In some embodiments, a thickness of the blocking layer 13 is 10 nm to 30 nm.

When the thickness of the blocking layer is within an appropriate range, the thermal stability and the photoelectric conversion efficiency of the solar cell can be improved simultaneously.

In some embodiments, the solar cell 1-1 and 1-2 may include a perovskite cell, a fuel-sensitized solar cell, and other devices. In some embodiments, the solar cell 1-1 and 1-2 includes a perovskite cell.

In some embodiments, as shown in FIG. 3 and FIG. 4, the active layer 11 includes a light-absorbing layer 111. In some embodiments, the light-absorbing layer 111 includes a perovskite compound.

In some examples, a thickness of the light-absorbing layer 111 is 400 nm to 1,000 nm. In some embodiments, a thickness of the light-absorbing layer 111 may be 400 nm, 500 nm, 600 nm, 700 nm, 800 nm, 900 nm, 1,000 nm, or within a range defined by any two of the above-mentioned values. In some embodiments, a thickness of the light-absorbing layer 111 is 500 nm to 900 nm.

In some embodiments, a band gap of the perovskite compound is 1.20 eV to 2.30 eV. In some embodiments, a band gap of the perovskite compound is optionally 1.20eV, 1.50 eV, 2.00 eV, 2.30 eV, or within a range defined by any two of the above-mentioned values.

In some embodiments, the perovskite compound contains a perovskite-type metal halide; a chemical formula of the perovskite-type metal halide is $ABX_3$; where A is a monovalent cation, B is a divalent cation, and X is a monovalent anion. In some embodiments, A includes one or more of $Cs^+$, $K^+$, $Rb^+$, a monovalent aminium cation, and a monovalent amidinium cation. Non-limiting examples of the monovalent aminium cation include $CH_3NH_3^+$ (methylamine, and $MA^+$), and ammonium ($NH_4^+$). Non-limiting examples of the monovalent amidinium cation include $NH_2CH=NH_2^+$ (formamidine, which may be denoted as $FA^+$). In some embodiments, B includes one or more of $Pb^{2+}$, $Sn^{2+}$, $Fe^{2+}$, $Mn^{2+}$, $Ni^{2+}$, $Ge^{2+}$, $Co^{2+}$, and $Sb^{2+}$. In some embodiments, X includes a halogen anion. In some embodiments, X includes at least one of $Cl^-$, $Br^-$, and $I^-$.

In some embodiments, as shown in FIG. 3 and FIG. 4, the active layer 11 further includes an electron transport layer 112, and the electron transport layer 112 is arranged between the light-absorbing layer 111 and the blocking layer 13.

In some embodiments, the electron transport layer 112 includes at least one of the following materials and derivatives thereof: [6,6]-phenyl-C61-butyric acid methyl ester ($PC_{61}BM$), [6,6]-phenyl-C71 butyric acid methyl ester ($PC_{71}BM$), and fullerene.

The blocking layer 13 is arranged on a surface of the electron transport layer 112. Compared with the blocking layer 13 being directly arranged on a surface of the light-absorbing layer 111, the damage to the light-absorbing layer 111 caused in the deposition process of the blocking layer 13 can be effectively reduced, and the negative impacts on the photoelectric conversion efficiency can be reduced.

In some embodiments, as shown in FIG. 3 and FIG. 4, the active layer 11 further includes a hole transport layer 113, and the hole transport layer 113 is arranged on a side of the light-absorbing layer 111 facing away from the blocking layer 13.

In some embodiments, the hole transport layer 113 includes at least one of the following materials and derivatives thereof: BTPA-series hole transport materials, poly[bis(4-phenyl)(2,4,6-trimethylphenyl)amine] (PTAA), 2,2',7,7'-tetra [N,N-di(4-methoxyphenyl)amino]-9,9'-spirobifluorene (Spiro-OMeTAD), poly-3-hexylthiophene ($P_3HT$), triphenylamine ($H_{101}$) with triptycene as the core, 3, 4-ethylenedioxythiophene-methoxytriphenylamine (EDOT-OMeTPA), N-(4-aniline) carbazole-spirobifluorene (CzPAF-SBF), poly(3, 4-ethylenedioxythiophene): polystyrene sulfonate (PEDOT: PSS), polythiophene, nickel oxide (NiOx), molybdenum oxide (MoO3), cuprous iodide (CuI), cuprous oxide ($Cu_2O$), etc.

In some embodiments, the first electrode layer 10 is a transparent electrode layer, and the second electrode layer 12 is a back electrode layer.

In some embodiments, the first electrode layer 10 includes at least one of: fluorine-doped tin oxide (FTO), indium tin oxide (ITO), aluminum-doped zinc oxide (AZO), boron-doped zinc oxide (BZO), indium zinc oxide (IZO), and indium tungsten oxide (IWO).

In some embodiments, a thickness of the first electrode layer 10 is 200 nm to 1,000 nm. In some embodiments, a thickness of the first electrode layer 10 may be 200 nm, 300 nm, 400 nm, 500 nm, 600 nm, 700 nm, 800 nm, 900 nm,1000 nm, or within a range defined by any two of the above-mentioned values.

In some embodiments, the second electrode layer 12 is generally a metal electrode, an inorganic electrode, or a metal-inorganic electrode mixed conductive material. In some embodiments, the back electrode layer 12 includes at least one of indium tin oxide (ITO), lanthanide metal-doped indium oxide, boron-doped zinc oxide (BZO), aluminum zinc oxide (AZO), indium zinc oxide (IZO), gallium zinc oxide (GZO), indium tungsten oxide (IWO), Au, Ag, Cu, Al, Ni, Cr, Bi, Pt, Mg, Mo, W and alloys thereof, graphite, graphene, and carbon nanotubes, optionally, Ag, Cu, C, Au, Al, ITO, AZO, BZO, or IZO, and further optionally, Cu, Ag, Au, or a combination thereof.

In some embodiments, a thickness of the second electrode layer 12 is 20 nm to 200 nm. In some embodiments, a thickness of the second electrode layer 12 may be 20 nm, 40 nm, 60 nm, 80 nm, 100 nm, 120 nm, 140 nm, 160 nm, 180 nm, 200 nm or within a range defined by any two of the above-mentioned values.

In some embodiments, as shown in FIG. 3, the solar cell 1-3 is an inverted p-i-n perovskite cell, including the first electrode layer 10, the hole transport layer 113, the light-absorbing layer 111, the electron transport layer 112, the blocking layer 13, and the second electrode layer 12 stacked in sequence.

In some embodiments, as shown in FIG. 4, the solar cell 1-4 is a regular n-i-p perovskite cell, including the first electrode layer 10, the blocking layer 13, the electron transport layer 112, the light-absorbing layer 111, the hole transport layer 113, and the second electrode layer 12 stacked in sequence.

In some embodiments, as shown in FIG. 3, the blocking layer 13 is arranged between the second electrode layer 12 and the active layer 11.

An electric field is in the active layer 11 (such as a perovskite compound), and halogen anions are prone to diffusion under the action of the electric field. The halogen anions have a low diffusion rate in n-type semiconductors. Using the n-type semiconductor oxide as the blocking layer 13 can not only play a role in blocking holes, but also block the diffusion of the halogen anions in the perovskite compound to the second electrode layer 12, thereby slowing down the corrosion of the second electrode layer 12 (such as a metal electrode), and improving the stability and the photoelectric conversion efficiency of the solar cell.

In some embodiments, as shown in FIG. 5, the blocking layer 13 further includes an extending part 131 arranged on at least one side surface of the active layer 11.

In some embodiments, a thickness of the extending part 131 of the blocking layer 13 is 5 nm to 35 nm. In some embodiments, a thickness of the extending part 131 of the blocking layer 13 is 10 nm to 30 nm. In some embodiments, a thickness of the extending part 131 of the blocking layer 13 is 5 nm, 10 nm, 15 nm, 20 nm, 25 nm, 30 nm, 35 nm, or within a range defined by any two of the above-mentioned values.

The extending part 131 arranged on at least one side surface of the active layer 11 can form a semi-encapsulated structure for the solar cell 1-5, thereby effectively preventing water and oxygen in the air from entering the active layer 11, especially preventing water and oxygen from aging the light-absorbing layer 111, slowing down the degradation of a perovskite material in the external environment, and improving the photoelectric conversion efficiency and the stability of the device.

In some embodiments, all parts of the blocking layer 13 are formed simultaneously.

All the parts of the blocking layer 13 are formed simultaneously during one deposition process, which can effectively improve the forming efficiency of the solar cell and alleviate the deterioration of the photoelectric conversion efficiency caused by damage to the active layer 11 in multiple deposition processes.

In some embodiments, the blocking layer 13 is formed through an atomic layer deposition method.

The atomic layer deposition method is a method by which the substrate surface may be plated with substances layer by layer in the form of a single atomic film layer.

A thin film prepared by the atomic layer deposition method has high compactness and can effectively block the diffusion of the halogen anions in the light absorbing layer 111 to the second electrode layer 12, and particularly, can alleviate the corrosion of the halogen anions to metal in the electrode layer, thereby effectively improving the stability and the photoelectric conversion efficiency of the solar cell. At the same time, the atomic layer deposition method is to alternately introduce gas phase precursor pulses into a reaction container. A first reaction precursor may be chemically adsorbed on a substrate. When being introduced into the reaction container, a second precursor will react with the previous precursor that has been adsorbed on a surface of the substrate to form the thin film. Therefore, film formation through the atomic layer deposition method is not restricted by the direction or angle, and the reaction precursor can be freely adsorbed on any exposed surface of the active layer, so that the parts of the blocking layer 13 in all directions can be formed simultaneously, which has the characteristics of high production efficiency and low costs.

In some embodiments, a highest occupied molecular orbital (HOMO) energy level of the n-type semiconductor oxide is lower than a HOMO energy level of the light-absorbing layer.

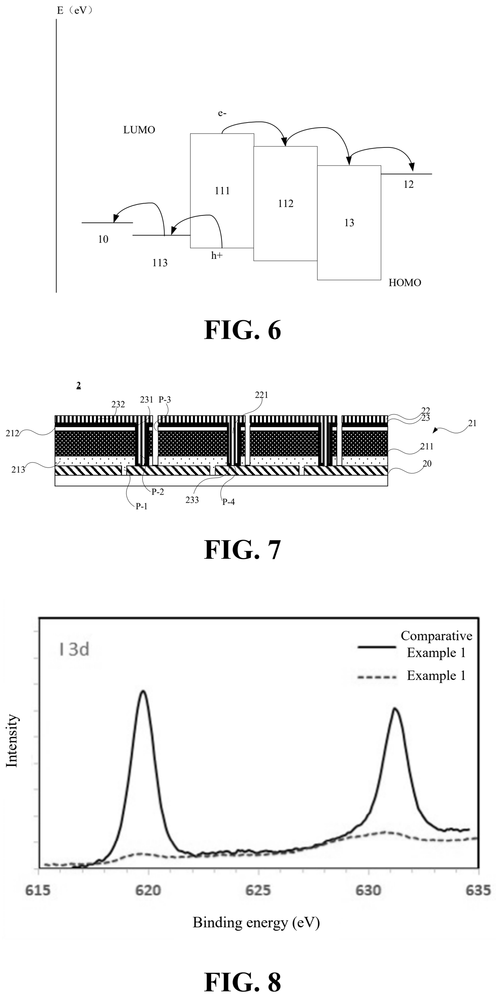

As shown in FIG. 6, the HOMO of the n-type semiconductor oxide is lower than the HOMO of the electron transport layer 112 and/or the light-absorbing layer 111, so that diffusion of the holes from the HOMO of the light-absorbing layer 111 to the HOMO of the n-type semiconductor oxide can be blocked, thereby acting as the blocking layer.

In some embodiments, a lowest unoccupied molecular orbital (LUMO) energy level of the n-type semiconductor oxide is -6 eV to -4.3 eV, and the HOMO energy level of the n-type semiconductor oxide is -8 eV to -6.2 eV.

As shown in FIG. 6, the HOMO of the n-type semiconductor oxide within the above-mentioned range is lower than the HOMO of the electron transport layer 112 and/or the light-absorbing layer 111, which can block the diffusion of the holes from the HOMO of the light-absorbing layer 111 to the HOMO of the n-type semiconductor oxide, thereby acting as a hole blocking layer; at the same time, the LUMO of the n-type semiconductor oxide matches the LUMO of the electron transport layer 112 and/or the light-absorbing layer 111, which is beneficial for the diffusion of electrons after transition from the LUMO of the light-absorbing layer 111 and/or the electron transport layer 112 to the blocking layer 13, thereby further improving the electron transport efficiency, and facilitating the improvement of the photoelectric conversion efficiency of the solar cell.

In a second aspect, the present application provides a preparation method for a solar cell. With continuing reference to FIG. 3, the preparation method includes: providing a first electrode layer 10; forming an active layer 11 on at least one side of the first electrode layer 10; forming a blocking layer 13 on a side of the active layer 11 facing away from the first electrode layer 10; and forming a second electrode layer 12 on a side of the blocking layer 13 facing away from the first electrode layer 10, where the blocking layer includes an n-type semiconductor oxide, optionally including at least one of tin oxide, titanium oxide, zinc oxide, indium oxide, and gallium oxide.

In some embodiments, the blocking layer 13 further includes an extending part 131 arranged on at least one side surface of the active layer 11.

In some embodiment, a forming method of the blocking layer 13 is an atomic layer deposition method.

In some embodiments, a forming method of the blocking layer 13 includes performing atomic layer deposition by reacting a metal source with an oxygen source.

In some embodiments, the metal source includes at least one of an organic tin source, an organic titanium source, and an organic zinc source.

In some embodiments, a tin source includes an organic tin source, optionally tetra(dimethylamino)tin.

In some embodiments, the oxygen source includes at least one of water and ozone.

In a third aspect, as shown in FIG. 6, the present application provides a solar cell module 2, including a first electrode layer 20, an active layer 21, a blocking layer 23, and a second electrode layer 22 stacked in sequence, where the blocking layer 23 includes an n-type semiconductor oxide, optionally, including at least one of tin oxide, titanium oxide, zinc oxide, indium oxide, and gallium oxide.

The solar cell module is formed by connecting several single solar cells in series or in parallel. Using the n-type semiconductor oxide as the blocking layer can block the migration of holes toward a cathode. The n-type semiconductor oxide is made from an inorganic material and has higher heat resistance compared with traditional blocking layer materials such as bathocuproine, so that the solar cell module has higher thermal stability.

In some embodiments, with continuing reference to FIG. 6, the first electrode layer 20 includes a plurality of conductive blocks that are not connected to each other, and a first separation groove P-1 is formed between every two adjacent conductive blocks; the active layer 21 includes a plurality of active blocks, and a second separation groove P-2 is formed between every two adjacent active blocks, a bottom surface of the second separation groove P-2 is arranged on the first electrode layer 20, and an opening of the second separation groove P-2 is formed in an upper surface of the active layer 21; the second electrode layer 22 is arranged on the blocking layer 23, and the second electrode layer 22 is further provided with a longitudinal part 221 extending toward the first electrode layer 20, the longitudinal part 221 passes through the second separation groove P-2, and a tail end of the longitudinal part 221 is connected to the bottom surface of the second separation groove P-2; the solar cell module 2 further includes a third separation groove P-3, an opening of the third separation groove P-3 is formed in an upper surface of the second electrode layer 22, and a bottom surface of the third separation groove P-3 is arranged on the first electrode layer 20.

The above-mentioned arrangement enables single solar cells to be connected in series to form the solar cell module through the simple arrangement of the separation groove, thereby effectively improving the preparation efficiency of the solar cell module.

In some embodiments, the blocking layer 23 at least includes a first horizontal part 232 located on an upper surface of the active block and a first extending part 231 extending toward the first electrode 20, and the first extending part 231 is arranged on at least one side surface of the active layer 21 adjacent to the second separation groove P-2.

The first horizontal part 232 and the first extending part 231 of the blocking layer 23 can respectively inhibit the longitudinal migration and lateral migration of halogen anions in the active layer 21 to the second electrode layer 22, thereby slowing down the corrosion to the second electrode layer 22 and improving the stability and the photoelectric conversion efficiency of the solar cell module.

In some embodiments, the blocking layer 23 further includes a second horizontal part 233 located on the bottom surface of the second separation groove P-2; a fourth separation groove P-4 is formed in the second horizontal part 233, and the longitudinal part 221 of the second electrode layer passes through the fourth separation groove P-4, so that the tail end thereof is connected to the first electrode layer 20 on the bottom surface P-2 of the second separation groove.

The longitudinal part 221 of the second electrode layer passes through the fourth separation groove P-4, so that the tail end thereof is connected to the first electrode layer 20 on the bottom surface of the second separation groove P-2, which can reduce the series resistance between the single solar cells and improve the photoelectric conversion efficiency of the solar cell module.

In some embodiments, a width of the fourth separation groove P-4 is less than that of the second separation groove P-2.

The above-mentioned arrangement enables the tail end of the longitudinal part 221 of the second electrode layer to be connected to the first electrode layer 20 on the bottom surface of the second separation groove P-2, and the arrangement of the fourth separation groove P-4 will not destroy the first extending part 231 of the blocking layer 23, so that the blocking layer can play an effective blocking role, thereby avoiding other negative effects on the photoelectric conversion efficiency and the stability of the solar cell module.

In some embodiments, the blocking layer 23 is formed through an atomic layer deposition method.

The atomic layer deposition method is a method by which the substrate surface may be plated with substances layer by layer in the form of a single atomic film layer. Therefore, a thin film deposited through the atomic layer deposition method has high compactness and can effectively block the diffusion of the halogen anions in the active layer 21 to the second electrode layer 22, and particularly, can alleviate the corrosion of the halogen anions to metal in the electrode layer, thereby effectively improving the stability and the photoelectric conversion efficiency of the solar cell. At the same time, the atomic layer deposition method is to alternately introduce gas phase precursor pulses into a reaction container. A first reaction precursor may be chemically adsorbed on a substrate. When being introduced into the reaction container, a second precursor will react with the previous precursor that has been adsorbed on a surface of the substrate to form the thin film. Therefore, film formation through the atomic layer deposition method is not restricted by the direction or angle, and the reaction precursor can be freely adsorbed on any exposed side surface of the active layer, so that the first extending part 231, the first horizontal part 232, and the second horizontal part 233 of the blocking layer can be formed simultaneously, which has the characteristics of high production efficiency and low costs.

In some embodiments, a thickness of the blocking layer 23 is 5 nm to 35 nm. In some embodiments, a thickness of the blocking layer 23 is 10 nm to 30 nm.

In some embodiments, the first horizontal part 232, the first extending part 231, and the second horizontal part 233 of the blocking layer 23 have the same thickness.

In some embodiments, the active layer 21 includes a light-absorbing layer.

In some embodiments, the light-absorbing layer 211 includes a perovskite compound.

In some embodiments, the active layer 21 further includes an electron transport layer 212, and the electron transport layer 212 is arranged between the light-absorbing layer 211 and the blocking layer 23.

In some embodiments, the active layer 21 further includes a hole transport layer 213, and the hole transport layer 213 is arranged between the light-absorbing layer 211 and the first electrode layer 20.

In a fourth aspect, the present application provides a preparation method for a solar cell module 2, including: providing a first electrode layer 20; forming at least one first separation groove P-1 in the first electrode layer 20, where the first separation groove P-1 divides the first electrode layer 20 into a plurality of conductive blocks that are not connected to each other; forming an active layer 21 on at least one side of the first electrode layer 20; forming at least one second separation groove P-2 in the active layer 21, where a bottom surface of the second separation groove P-2 is arranged on the first electrode layer 20, and an opening of the second separation groove P-2 is formed in an upper surface of the active layer 21; forming a blocking layer 23 on a side of the active layer 21 facing away from the first electrode layer 20; forming a second electrode layer 22 on a side of the blocking layer 23 facing away from the first electrode layer 20, where the second electrode layer 22 is provided with a longitudinal part 221 extending toward the first electrode layer 20, the second separation groove P-2 is filled with the longitudinal part 221, and a tail end of the longitudinal part 221 is connected to the first electrode layer 20 at a bottom of the second separation groove P-2; and forming a third separation groove P-3, where an opening of the third separation groove P-3 is formed in an upper surface of the second electrode layer 22, and a bottom surface of the third separation groove P-3 is arranged on the first electrode layer 20; where the blocking layer includes an n-type semiconductor oxide, optionally including at least one of tin oxide, titanium oxide, zinc oxide, indium oxide, and gallium oxide.

Unlike the prior art, the second separation groove P-2 is formed prior to deposition of the blocking layer 23, so that the blocking layer 23 can be deposited simultaneously on the upper surface of the active block and at least one side surface of the active block adjacent to the second separation groove P-2, thereby improving the production efficiency while improving the photoelectric conversion efficiency and the stability of the solar cell module.

In any embodiment, the blocking layer 23 is formed at least on an upper surface of the active block and at least one side surface of the active block adjacent to the second separation groove P-2.

In some embodiments, the blocking layer 23 is formed through an atomic layer deposition method.

In some embodiments, the blocking layer 23 is further formed in the bottom surface of the second separation groove P-2; a fourth separation groove P-4 is formed in the blocking layer 23 located on the bottom surface of the second separation groove P-2, the longitudinal part 221 of the second electrode layer passes through the fourth separation groove P-4, and the tail end of the longitudinal part 221 is connected to the first electrode layer 20 on the bottom surface of the second separation groove P-2.

In some embodiments, at least one of the first separation groove P-1, the second separation groove P-2, the third separation groove P-3, and the fourth separation groove P-4 is formed through laser cutting.

Laser cutting is precise and efficient, and can effectively improve the processing accuracy of the solar cell module and reduce manufacturing costs.

In a fifth aspect, the present application provides an electrical device, including the solar cell in any embodiment or a solar cell prepared by the preparation method in any embodiment or the solar cell module in any embodiment or a solar cell module prepared by the preparation method in any embodiment.

In some embodiments, the solar cell or the solar cell module can be used as a power generation apparatus for an electrical apparatus. Types of the power generation apparatuses may include, but are not limited to, integrated power generation.

The electrical apparatus may include mobile devices, such as a mobile phone, a tablet personal computer, a laptop computer, a calculator, a watch, an automobile, an electric train, a ship, a satellite, a power generation system, etc., but are not limited thereto.

The power generation apparatus may be arranged on, but not limited to the roof, back panel, etc. of the automobile.

The following embodiments more specifically describe the contents disclosed in the present application. These embodiments are intended for illustrative purposes only, because various modifications and changes made within the scope of the contents disclosed in the present application will be apparent to those skilled in the art. Unless otherwise stated, all parts, percentages, and ratios reported in the following embodiments are based on weight, all reagents used in the embodiments are either commercially available or synthesized according to conventional methods, and may be directly used without further processing, and all the instruments used in the embodiments are commercially available.

**Examples**

**Preparation method**

Example 1

An embodiment of the present application provides a manufacturing method for a solar cell module, and the manufacturing method includes the following steps:

The first electrode layer was prepared: The etched FTO conductive glass was ultrasonically cleaned several times with water, acetone, and isopropyl alcohol in sequence, and then blown dry with nitrogen for use as the first electrode layer.

The cleaned FTO substrate was scribed with laser to form the first separation groove (P1), and an FTO conductive layer was etched away to expose the substrate.

The hole transport layer was prepared: The transparent conductive glass substrate was treated with ultraviolet ozone, followed by magnetron-sputtering an approximately 30 nm thick nickel oxide layer, which was then annealed at 300°C for 60 min to obtain the hole transport layer.

The perovskite layer was prepared: The perovskite light-absorbing layer was prepared using a one-step method, the perovskite precursor solution was spin-coated on the hole transport layer at a rate of 3,000-5,000 rpm for 20-40 s, around the 10th second after the start of spin-coating, 300-600 $\mu$L of anti-solvent was added dropwise, and a thin film was then placed on a hotplate and annealed at 100-120°C for 60 min to obtain the perovskite layer with a thickness of 600 nm.

The perovskite precursor solution was prepared by dissolving 116.91 mg of cesium iodide, 94.19 mg of methylammonium chloride, 1440.94 mg of formamidinium iodide, 4356.54 mg of lead iodide, 66.06 mg of lead bromide, and 111.97 mg of methylammonium bromide in 6 mL of a mixed solvent of DMF and DMSO (the volume ratio of DMF to DMSO of 4:1), with anisole used as the anti-solvent.

The electron transport layer was prepared: The thin film with the perovskite layer was placed into an evaporation instrument until the vacuum degree of evaporation reached $5 \times 10^{-4}$ Pa or below, and an 20 nm electron transport layer $C_{60}$ was evaporated at a rate of 0.05 A/s.

The second separation groove with a width of 50 $\mu$m was manufactured on the electron transport layer using laser, and the hole transport layer, the light-absorbing layer, and the electron transport layer were etched away to expose the first electrode layer.

A tin dioxide layer with a thickness of approximately 25 nm was prepared, using the atomic layer deposition technology, on the substrate provided with the second separation groove in a scribing manner, serving as the blocking layer; the blocking layer was deposited on any exposed surface on the substrate provided with the second separation groove in the scribing manner, including the upper surface and side surfaces of the active block and the bottom surface of the second separation groove. The specific deposition process was as follows: the tin source used was tetra(dimethylamino)tin (TDMASn), the oxygen source used was water, the pulse and purge time is as follows: TDMASn 0.5 s, nitrogen 3 s, water 0.5 s, and nitrogen 5 s, the local pressure was 50 mtorr, the purge flow rate was 5,000 sccm, the reaction temperature was 100°C, and the source temperature was 45°C.

The blocking layer on the bottom surface of the second separation groove was etched away by laser scribing at the middle position of the bottom of the second separation groove to manufacture the fourth separation groove with a width of 30 $\mu$m, so that tin dioxide on the side surface of the second separation groove cannot be damaged while the first electrode layer underneath was exposed.

The thin film with the blocking layer was placed in an evaporation instrument. After the vacuum degree of evaporation reached $5 \times 10^{-4}$ Pa or below, a 80 nm Cu metal electrode was evaporated at a rate of 0.1 A/s to serve as the second electrode layer. The second separation groove was also filled with metal copper which was connected to the first electrode layer exposed at the bottom of the second separation groove.

The third separation groove was manufactured on the second electrode layer by using laser, and all functional layer thin films on the first electrode layer were etched away to obtain the solar cell module.

The preparation methods of Examples 2 and 3 are basically the same as that of Example 1, except that the composition of the blocking layer was changed; in the atomic layer deposition process of Example 2, $Ti(NMe_2)_4$ was used as the titanium source, water was used as the oxygen source, and the blocking layer included titanium dioxide; in the atomic layer deposition process of Example 3, $ZnMe_2$ was used as the zinc source, water was used as the oxygen source, and the blocking layer included zinc oxide.

In Example 4, fluorine-doped tin dioxide was used as the target material, and a 25 nm thick impedance layer was prepared by magnetron-sputtering deposition.

The preparation methods of Examples 5-8 are basically the same as that of Example 1, except that the thickness of the blocking layer was changed by adjusting the deposition time of the blocking layer.

The preparation method of Example 9 is basically the same as that of Example 1, except that the side surface of the active layer was shielded in the atomic layer deposition process, so that only the atomic layer of the blocking layer was deposited on the surface of the active layer and not deposited on the side surface thereof.

The preparation method of Example 10 is basically the same as that of Example 1, except that the fourth separation groove was not formed, and the second electrode cannot be in direct contact with the first electrode.

The preparation method of Example 11 is basically the same as that of Example 1, except that tin dioxide of the blocking layer was deposited and prepared through a magnetron-sputtering method by using tin dioxide as a target material.

The steps of Comparative Example 1 are basically the same as those of Example 1, except that the component of the blocking layer in Comparative Example 1 is bathocuproine (BCP), and the deposition method of the blocking layer is as follows:

The BCP blocking layer was prepared by a spin-coating method, with a concentration of 5 mg/mL, isopropanol as the solvent, a spin-coating speed of 4000 rpm, time of 30 s, and the thickness of the blocking layer of 10 nm.

After deposition of the blocking layer was completed, the second separation groove was made using laser, with the width of 50 $\mu$m, the hole transport layer, the light-absorbing layer, the electron transport layer, and the blocking layer were etched away to expose the first electrode layer.

The above-mentioned thin film was placed in an evaporation instrument. After the vacuum degree of evaporation reached $5\times10^{-4}$ Pa or below, a 80 nm Cu metal electrode was evaporated at a rate of 0.1 A/s to serve as the second electrode layer. The second separation groove was also filled with metal copper which was connected to the first electrode layer exposed at the bottom of the second separation groove.

The third separation groove was manufactured on the second electrode layer by using laser, and all functional layer thin films on the first electrode layer were etched away to obtain the solar cell module.

Example 21

A manufacturing method for a single solar cell is as follows.

The FTO conductive glass with a specification of $2.0\times2.0$ cm$^2$ was taken, and 0.35 cm of FTO at each end was removed by laser etching to expose the glass substrate.

The etched FTO conductive glass was ultrasonically cleaned with water, acetone, and isopropyl alcohol in sequence.

The FTO conductive glass was blown dry under a nitrogen gun to evaporate the solvent and placed in an ultraviolet ozone machine for further cleaning.

10 mg/mL of nickel oxide nanoparticles (with an aqueous solution as a solvent) were spin-coated on the FTO substrate after ultraviolet ozone treatment at a rate of 4000 rpm to form the hole transport layer, followed by annealing treatment on a hotplate at 100°C for 30 min.

The perovskite precursor solution was spin-coated on the hole transport layer at 1000-5000 rpm/s, annealing was performed at 100°C for 30 min, and cooling was performed to room temperature, where an absorbing layer is a $1.4MCs_{0.05}(FA_{0.83}MA_{0.17})_{0.95}Pb(I_{0.83}Br_{0.17})_3$ perovskite system.

The electron transport layer PCBM was spin-coated on the perovskite layer at 1500rpm and annealed at 100°C for 10 min.

A 25 nm thick tin dioxide layer was prepared on the electron transport layer by using an atomic layer deposition device, serving as the blocking layer. In the atomic layer deposition process, the tin dioxide layer was simultaneously deposited on the upper surface of the electron transport layer and the exposed side surface of the device. The blocking layers deposited on the side surface and the upper surface were both approximately 25 nm thick.

The above-mentioned product was placed in an evaporation machine, and a Cu metal electrode was evaporated to obtain a cell device.

The preparation methods of Examples 22 and 23 are basically the same as that of Example 21, except that the deposited composition was changed; in the atomic layer deposition process of Example 22, $Ti(NMe_2)_4$ was used as the titanium source, water was used as the oxygen source, and the blocking layer included titanium dioxide; in the atomic layer deposition process of Example 23, $ZnMe_2$ was used as the zinc source, water was used as the oxygen source, and the blocking layer included zinc oxide.

In Example 24, fluorine-doped tin dioxide (FTO) was deposited through a magnetron-sputtering method.

Examples 25-28 are basically the same as Example 21, except that the thickness of the blocking layer was changed by adjusting the deposition time.

The preparation method of Example 29 is basically the same as that of Example 21, except that the side surface of the active layer was shielded in the deposition process, so that only the atomic layer of the blocking layer was deposited on the surface of the active layer.

The preparation method of Example 30 is basically the same as that of Example 21, except that tin dioxide was deposited through a magnetron-sputtering method by using tin dioxide as a target material.

The preparation method of Comparative Example 2 was basically the same as that of Example 13, except that the component of the blocking layer in Comparative Example 2 is bathocuproine (BCP), and the deposition method is as follows:

The BCP blocking layer was prepared by a spin-coating method, with a concentration of 5 mg/mL, isopropanol as the solvent, a spin-coating speed of 4,000 rpm, and time of 30 s.

The blocking layer was only deposited on the upper surface of the layer and cannot be deposited on the side surface of the active layer at the same time.

**Test Method**

1. Photoelectric conversion efficiency test

The cell performance was tested using a Keithley 2400SMU, AM 1.5G solar radiation test system under a 100 mW/cm2 light source. The photoelectric conversion efficiency was calculated as follows:

$$PCE = Pout/Popt$$

$$= Voc\times Jsc\times(Vmpp\times Jmpp)/(Voc\times Jsc\times Popt)$$

$$= Voc\times Jsc\times FF/Popt$$

Pout (mW/cm$^2$), Popt (mW/cm$^2$), Vmpp (V), Jmpp (mA/cm$^2$), Voc (V) and Jsc (mA/cm$^2$) were the working output power of the cell, the power of the incident light, the maximum power point voltage of the cell, the maximum power point current of the cell, the open-circuit voltage, and the short-circuit current density, respectively.

For the solar cell module, Jsc thereof was calculated by dividing the short-circuit current by the area of the solar cell module.

For the single solar cell, Jsc thereof was calculated by dividing the short-circuit current by the area of the single solar cell.

2. Stability test

The solar cell or the cell module was placed on a hotplate at 65°C and heated continuously. The change in the photoelectric conversion efficiency thereof with aging time was tracked, and the time required for the photoelectric conversion efficiency thereof to decay to 80% of the initial efficiency was recorded as T80. The magnitude of the parameter indicates the level of the thermal stability of the perovskite solar cell or the cell module.

3. Hole mobility test

The principle of the hole mobility test was to use the Hall effect to measure the mobility of holes in semiconductor materials. The Hall effect refers to the fact that when the current passes through semiconductor materials under the action of a magnetic field, a transverse electric field may be generated, and this electric field is called the Hall electric field. The magnitude of the Hall electric field is related to the current, the magnetic field, and the properties of the semiconductor materials. The Ecopia HMS-3000 Hall effect tester was used to measure the magnitude and direction of the Hall electric field, so as to calculate the mobility of the holes in the semiconductor materials.

4. Energy level test

The energy level test was performed using an ultraviolet photoelectron spectrum (UPS). The UPS uses ultraviolet to excite the sample surface, causing photoelectrons to be emitted from the sample surface.

Sample size: Less than 1x1 cm$^2$, with the thickness less than 2 mm.
Sample preservation: It was ensured that the sample surface is free of contamination before the test.
Sample preparation: The thin film sample to be tested needed to be made on the conductive glass substrate and then fixed on a sample stage with conductive tape to ensure good conductivity.

In the UPS, the secondary electron cutoff edge $E_{cutoff}$ corresponds to the position of the highest binding energy of the detected electron, that is, the position corresponding to the lowest kinetic energy. The work function is usually determined in combination with the position of the Fermi edge. The HOMO energy level of the thin film was calculated using the UPS, and then the LUMO energy level of the thin film can be calculated using the band gap.

5. X-ray photoelectron spectroscopy (XPS) test

After the device was aged for 96 hours, the components on the second electrode side were subjected to an XPS test using an XPS instrument.

XPS analysis software can compare the peaks of the same element under different test conditions. By comparing the peak position and peak intensity, information such as the relevant element content and chemical potential can be obtained.

**Test results**

Table 1

| Serial number | Blocking layer | | | $T_{80}$ (h) |
|---|---|---|---|---|
| | Composition | Thickness/nm | Preparation method | |
| Example 1 | SnO$_2$ | 25 | Deposited on the surface and the side surface via atomic layer deposition | 400 |
| Example 2 | TiO$_2$ | 25 | Deposited on the surface and the side surface via atomic layer deposition | 396 |
| Example 3 | ZnO | 25 | Deposited on the surface and the side surface via atomic layer deposition | 392 |
| Example 4 | Fluorine-doped SnO$_2$ | 25 | Deposited on the surface via magnetron-sputtering | 320 |
| Example 5 | SnO$_2$ | 30 | Deposited on the surface and the side surface via atomic layer deposition | 360 |
| Example 6 | SnO$_2$ | 35 | Deposited on the surface and the side surface via atomic layer deposition | 340 |
| Example 7 | SnO$_2$ | 10 | Deposited on the surface and the side surface via atomic layer deposition | 352 |
| Example 8 | SnO$_2$ | 5 | Deposited on the surface and the side surface via atomic layer deposition | 338 |
| Example 9 | SnO$_2$ | 25 | Deposited only on the surface via atomic layer deposition | 330 |
| Example 10 | SnO$_2$ | 25 | Without the fourth separation groove | 380 |
| Example 11 | SnO$_2$ | 25 | Magnetron-sputtering deposition | 328 |
| Comparative example 1 | BCP | 10 | Deposited on the surface with a spin-coating method | 260 |

Table 2

| Serial number | Blocking layer | | | T$_{80}$ (h) |
|---|---|---|---|---|
| | Composition | Thickness/nm | Preparation method | |
| Example 21 | SnO$_2$ | 25 | Deposited on the surface and the side surface via atomic layer deposition | 500 |
| Example 22 | TiO$_2$ | 25 | Deposited on the surface and the side surface via atomic layer deposition | 498 |
| Example 23 | ZnO | 25 | Deposited on the surface and the side surface via atomic layer deposition | 495 |
| Example 24 | Fluorine-doped SnO$_2$ | 25 | Magnetron-sputtered on the surface | 390 |
| Example 25 | SnO$_2$ | 30 | Deposited on the surface and the side surface via atomic deposition | 480 |
| Example 26 | SnO$_2$ | 35 | Deposited on the surface and the side surface via atomic deposition | 462 |
| Example 27 | SnO$_2$ | 10 | Deposited on the surface and the side surface via atomic deposition | 470 |
| Example 28 | SnO$_2$ | 5 | Deposited on the surface and the side surface via atomic deposition | 450 |
| Example 29 | SnO$_2$ | 25 | Deposited only on the surface via atomic deposition | 420 |
| Example 30 | SnO$_2$ | 25 | Magnetron-sputtering deposition | 396 |
| Comparative example 2 | BCP | 10 | Deposited on the surface with a spin-coating method | 300 |

Table 3

| Serial number | Blocking layer | | | PCE (%) |
|---|---|---|---|---|
| | Composition | Thickness/nm | Preparation method | |
| Example 1 | SnO$_2$ | 25 | Deposited on the surface and the side surface via atomic layer deposition | 20.34 |
| Example 2 | TiO$_2$ | 25 | Deposited on the surface and the side surface via atomic layer deposition | 20.18 |
| Example 3 | ZnO | 25 | Deposited on the surface and the side surface via atomic layer deposition | 19.86 |
| Example 4 | Fluorine-doped SnO$_2$ | 25 | Deposited on the surface via magnetron-sputtering | 9.14 |
| Example 5 | SnO$_2$ | 30 | Deposited on the surface and the side surface via atomic layer deposition | 18.66 |
| Example 6 | SnO$_2$ | 35 | Deposited on the surface and the side surface via atomic layer deposition | 16.98 |
| Example 7 | SnO$_2$ | 10 | Deposited on the surface and the side surface via atomic layer deposition | 18.52 |
| Example 8 | SnO$_2$ | 5 | Deposited on the surface and the side surface via atomic layer deposition | 16.73 |
| Example 9 | SnO$_2$ | 25 | Deposited only on the surface via atomic layer deposition | 20.29 |

(continued)

| Serial number | Blocking layer | | | PCE (%) |
|---|---|---|---|---|
| | Composition | Thickness/nm | Preparation method | |
| Example 10 | SnO$_2$ | 25 | Without the fourth separation groove | 17.8 |
| Example 11 | SnO$_2$ | 25 | Magnetron-sputtering deposition | 15.61 |

Table 4

| Serial number | Blocking layer | | | PCE (%) |
|---|---|---|---|---|
| | Composition | Thickness/nm | Preparation method | |
| Example 21 | SnO$_2$ | 25 | Deposited on the surface and the side surface via atomic layer deposition | 21.45 |
| Example 22 | TiO$_2$ | 25 | Deposited on the surface and the side surface via atomic layer deposition | 21.3 |
| Example 23 | ZnO | 25 | Deposited on the surface and the side surface via atomic layer deposition | 20.74 |
| Example 24 | Fluorine-doped SnO$_2$ | 25 | Magnetron-sputtered on the surface | 10.1 |
| Example 25 | SnO$_2$ | 30 | Deposited on the surface and the side surface via atomic deposition | 19.9 |
| Example 26 | SnO$_2$ | 35 | Deposited on the surface and the side surface via atomic deposition | 17.49 |
| Example 27 | SnO$_2$ | 10 | Deposited on the surface and the side surface via atomic deposition | 20.26 |
| Example 28 | SnO$_2$ | 5 | Deposited on the surface and the side surface via atomic deposition | 17.32 |
| Example 29 | SnO$_2$ | 25 | Deposited only on the surface via atomic deposition | 20.7 |
| Example 30 | SnO$_2$ | 25 | Magnetron-sputtering deposition | 16.29 |

As can be seen from Table 1, in Examples 1-11, the blocking layer of the solar cell module includes the n-type semiconductor oxide. Compared with the solar cell module using bathocuproine as the blocking layer in Comparative Example 1, the thermal stability of the solar cell module in the Examples is significantly improved.

As can be seen from Table 2, in Examples 21-30, the blocking layer of the single solar cell includes the n-type semiconductor oxide. Compared with the single solar cell using bathocuproine as the blocking layer in Comparative Example 2, the thermal stability of the single solar cell in the Examples is significantly improved.

As shown in FIG. 8, after the solar cell module in Example 1 is aged for 96 hours, the detectable iodine content in the second electrode layer is significantly lower than that the iodine content in the second electrode layer in the solar cell module in Comparative Example 1. This indicates that tin oxide in the blocking layer in Example 1 effectively inhibits the diffusion of halogen in perovskite into the second electrode layer.

In Example 1, the HOMO energy level of tin dioxide is -7.8 eV, and is lower than the HOMO energy level of perovskite, which is -5.4 eV, and the HOMO energy level of PCBM, which is -6 eV, acting as a blocking layer. The LUMO energy level of tin dioxide is -4.4 eV, and lower than the LUMO energy level of perovskite, which is -4 eV, and the LUMO energy level of PCBM, which is -4.3 eV. Compared with titanium dioxide (LUMO energy level of -4.5 eV) and zinc oxide (LUMO energy level of -4.6 V) as the blocking layer, the energy level of tin dioxide is more matched with the electron transport layer, and the photoelectric conversion efficiency is further improved.

The hole mobility of tin dioxide in Example 1 is 21 cm$^2$/(Vs), and the hole mobility of fluorine-doped tin dioxide in Example 4 is 10$^5$ cm$^2$/(Vs). Compared with the fluorine-doped tin dioxide in Example 4, tin dioxide in Example 1 plays a role in blocking holes. Therefore, the photoelectric conversion efficiency of the solar cell module is further improved.

From the comparison between Example 1 and Example 9, it can be seen that the solar cell module including the first extending part arranged on the side surface of the active layer adjacent to the second separation groove can further improve the thermal stability of the solar cell module.

From the comparison between Example 21 and Example 29, it can be seen that the single solar cell including the extending part arranged on the side surface of the active layer can play a semi-encapsulation role, which further improves the thermal stability of the single solar cell.

From the comparison between Example 1 and Example 10, it can be seen that the solar cell module including the fourth separation groove enables the tail end of the longitudinal part of the second electrode layer to be connected to the first electrode layer on the bottom surface of the second separation groove, which can reduce the series resistance, thereby further improving the photoelectric conversion efficiency of the solar cell module.

From the comparison between Example 1 and Example 11, and the comparison between Example 21 and Example 30, it can be seen that the atomic layer deposition method does not cause excessive energy damage to the perovskite layer, which is beneficial to improving the photoelectric conversion efficiency of the solar cell module/single solar cell. Moreover, the blocking layer deposited through the atomic layer deposition method is denser, which can better inhibit the diffusion of halogen ions in the perovskite layer to the metal electrode, thereby further improving the thermal stability of the solar cell module/single solar cell.

Finally, it should be noted that, the above embodiments are merely used for describing the technical solution of the present application, instead of limiting the present application. Although the present application is described in detail with reference to the foregoing embodiments, those of ordinary skill in the art should understand that they can still make modifications on the technical solution recorded in the above embodiments, or perform equivalent replacements on all or a part of technical features thereof; these modifications or replacements are not intended to make the essences of the corresponding technical solutions depart from the scope of the technical solutions of the embodiments of the present application, and they shall all be included within the scope of the claims and the specification of the present application. In particular, the technical features mentioned in the various embodiments can be combined in any manner as long as there is no structural conflict. The present application is not limited to the specific embodiments disclosed herein, but includes all technical solutions falling within the scope of the claims.

## Claims

1.  A solar cell, comprising:

    a first electrode layer, an active layer, a second electrode layer, and
    a blocking layer stacked in sequence, wherein the blocking layer is located between the active layer and the second electrode layer or located between the active layer and the first electrode layer, and the blocking layer comprises an n-type semiconductor oxide.

2.  The solar cell according to claim 1, wherein hole mobility of the n-type semiconductor oxide is not greater than 1000 $cm^2V^{-1}s^{-1}$, optionally, 0.1 $cm^2V^{-1}s^{-1}$ to 1000 $cm^2V^{-1}s^{-1}$.

3.  The solar cell according to claim 1 or 2, wherein the n-type semiconductor oxide comprises at least one of tin oxide, titanium oxide, zinc oxide, indium oxide, and gallium oxide.

4.  The solar cell according to any one of claims 1 to 3, wherein a thickness of the blocking layer is 5 nm to 35 nm, optionally 10 nm to 30 nm.

5.  The solar cell according to any one of claims 1 to 4, wherein the blocking layer is arranged between the second electrode layer and the active layer.

6.  The solar cell according to any one of claims 1 to 5, wherein the blocking layer further comprises an extending part arranged on at least one side surface of the active layer.

7.  The solar cell according to any one of claims 1 to 6, wherein the blocking layer is prepared by an atomic layer deposition method.

8.  The solar cell according to any one of claims 1 to 7, wherein the active layer comprises a light-absorbing layer, optionally, the light-absorbing layer comprises a perovskite compound.

9. The solar cell according to any one of claims 1 to 8, wherein the active layer further comprises an electron transport layer, and the electron transport layer is arranged between the light-absorbing layer and the blocking layer.

10. The solar cell according to any one of claims 1 to 9, wherein the active layer further comprises a hole transport layer, and the hole transport layer is arranged on a side of the light-absorbing layer facing away from the blocking layer.

11. The solar cell according to any one of claims 1 to 10, wherein a highest occupied molecular orbital (HOMO) energy level of the n-type semiconductor oxide is lower than a HOMO energy level of the light-absorbing layer.

12. A preparation method for a solar cell, wherein the preparation method comprises:

    providing a first electrode layer;
    forming an active layer on at least one side of the first electrode layer;
    forming a blocking layer on a side of the active layer facing away from the first electrode layer; and
    forming a second electrode layer on a side of the blocking layer facing away from the first electrode layer,
    wherein the blocking layer comprises an n-type semiconductor oxide, optionally comprising at least one of tin oxide, titanium oxide, zinc oxide, indium oxide, and gallium oxide.

13. The preparation method according to claim 12, wherein the blocking layer further comprises an extending part arranged on at least one side surface of the active layer.

14. The preparation method according to claim 12 to 13, wherein a forming method of the blocking layer is an atomic layer deposition method.

15. A solar cell module, comprising a first electrode layer, an active layer, a blocking layer, and a second electrode layer stacked in sequence,
    wherein the blocking layer comprises an n-type semiconductor oxide, optionally comprising at least one of tin oxide, titanium oxide, zinc oxide, indium oxide, and gallium oxide.

16. The solar cell module according to claim 15, wherein

    the first electrode layer comprises a plurality of conductive blocks that are not connected to each other, and a first separation groove is formed between every two adjacent conductive blocks;
    the active layer comprises a plurality of active blocks, and a second separation groove is formed between every two adjacent active blocks, a bottom surface of the second separation groove is arranged on the first electrode layer, and an opening of the second separation groove is formed in an upper surface of the active layer;
    the second electrode layer is arranged on the blocking layer, and the second electrode layer is further provided with a longitudinal part extending toward the first electrode layer, the longitudinal part passes through the second separation groove, and a tail end of the longitudinal part is connected to the bottom surface of the second separation groove;
    the solar cell module further comprises a third separation groove, an opening of the third separation groove is formed in an upper surface of the second electrode layer, and a bottom surface of the third separation groove is arranged on the first electrode layer.

17. The solar cell module according to claim 15 or 16, wherein the blocking layer at least comprises a first horizontal part located on an upper surface of the active block and a first extending part extending toward the first electrode, and the first extending part is arranged on at least one side surface of the active layer adjacent to the second separation groove.

18. The solar cell module according to any one of claims 15 to 17, wherein the blocking layer further comprises a second horizontal part located on the bottom surface of the second separation groove;
    a fourth separation groove is formed in the second horizontal part, and the longitudinal part of the second electrode layer passes through the fourth separation groove, so that the tail end thereof is connected to the first electrode layer on the bottom surface of the second separation groove.

19. The solar cell module according to claim 18, wherein a width of the fourth separation groove is less than that of the second separation groove.

20. The solar cell module according to any one of claims 15 to 19, wherein the blocking layer is prepared by an atomic layer deposition method; optionally, a thickness of the blocking layer is 5 nm to 35 nm, optionally, 10 nm to 30 nm.

21. The solar cell module according to any one of claims 15 to 20, wherein the active layer comprises a light-absorbing layer,

optionally, the light-absorbing layer comprises a perovskite compound,
optionally, the active layer further comprises an electron transport layer, and the electron transport layer is arranged between the light-absorbing layer and the blocking layer;
optionally, the active layer further comprises a hole transport layer, and the hole transport layer is arranged between the light-absorbing layer of the cell and the first electrode layer.

22. A preparation method for a solar cell module, wherein the preparation method comprises:

providing a first electrode layer;
forming at least one first separation groove in the first electrode layer, wherein the first separation groove divides the first electrode layer into a plurality of conductive blocks that are not connected to each other;
forming an active layer on at least one side of the first electrode layer;
forming at least one second separation groove in the active layer, wherein a bottom surface of the second separation groove is arranged on the first electrode layer, and an opening of the second separation groove is formed in an upper surface of the active layer;
forming a blocking layer on a side of the active layer facing away from the first electrode layer;
forming a second electrode layer on a side of the blocking layer facing away from the first electrode layer, wherein the second electrode layer is provided with a longitudinal part extending toward the first electrode layer, the second separation groove is filled with the longitudinal part, and a tail end of the longitudinal part is connected to the first electrode layer at a bottom of the second separation groove; and
forming a third separation groove, wherein an opening of the third separation groove is formed in an upper surface of the second electrode layer, and a bottom surface of the third separation groove is arranged on the first electrode layer;
wherein the blocking layer comprises an n-type semiconductor oxide, optionally comprising at least one of tin oxide, titanium oxide, zinc oxide, indium oxide, and gallium oxide.

23. The preparation method according to claim 22, wherein the blocking layer is formed at least on an upper surface of the active block and at least one side surface of the active block adjacent to the second separation groove.

24. The preparation method according to claim 22 or 23, wherein the blocking layer is prepared by an atomic layer deposition method.

25. The preparation method according to any one of claims 22 to 24, wherein

the blocking layer is further formed in the bottom surface of the second separation groove;
a fourth separation groove is formed in the blocking layer located on the bottom surface of the second separation groove,
the longitudinal part of the second electrode layer passes through the fourth separation groove, and the tail end of the longitudinal part is connected to the first electrode layer on the bottom surface of the second separation groove.

26. An electrical device, comprising the solar cell according to any one of claims 1 to 11, or a solar cell prepared by the preparation method according to any one of claims 12 to 14, or the solar cell module according to any one of claims 15 to 21, or a solar cell module prepared by the preparation method according to any one of claims 22 to 25.

1-1

**FIG. 1**

1-2

**FIG. 2**

1-3

**FIG. 3**

1-4

**FIG. 4**

1-5

**FIG. 5**

**FIG. 6**

**FIG. 7**

**FIG. 8**

## INTERNATIONAL SEARCH REPORT

| International application No. |
| --- |
| **PCT/CN2024/089625** |

**A. CLASSIFICATION OF SUBJECT MATTER**

H10K30/50(2023.01)i

According to International Patent Classification (IPC) or to both national classification and IPC

**B. FIELDS SEARCHED**

Minimum documentation searched (classification system followed by classification symbols)

H01L,H10K

Documentation searched other than minimum documentation to the extent that such documents are included in the fields searched

Electronic data base consulted during the international search (name of data base and, where practicable, search terms used)

CNABS, CNTXT, ENTXT, ENTXTC, CNKI, DWPI: 太阳能, 电池, 钙钛矿, 阻挡层, perovskite, solar, cell, barrier, layer

**C. DOCUMENTS CONSIDERED TO BE RELEVANT**

| Category* | Citation of document, with indication, where appropriate, of the relevant passages | Relevant to claim No. |
| --- | --- | --- |
| X | CN 116096109 A (XIDIAN UNIVERSITY) 09 May 2023 (2023-05-09) description, paragraphs 5-97, and figure 1 | 1-26 |
| X | CN 108682740 A (SUZHOU GCL NANO TECHNOLOGY CO., LTD. et al.) 19 October 2018 (2018-10-19) description, paragraphs 38-112 | 1-15, 20-21, 26 |

☐ Further documents are listed in the continuation of Box C.　☑ See patent family annex.

| | |
| --- | --- |
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **07 July 2024** | **09 July 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

### INTERNATIONAL SEARCH REPORT
**Information on patent family members**

International application No.

**PCT/CN2024/089625**

| Patent document cited in search report | | | Publication date (day/month/year) | Patent family member(s) | Publication date (day/month/year) |
|---|---|---|---|---|---|
| CN | 116096109 | A | 09 May 2023 | None | |
| CN | 108682740 | A | 19 October 2018 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310967471